# EUROPÄISCHE PATENTSCHRIFT

(11) **EP 1 220 314 B1**
(45) Veröffentlichungstag und Bekanntmachung des Hinweises auf die Patenterteilung: **19.09.2007**
(21) Anmeldenummer: 01129785.0
(22) Anmeldetag: 14.12.2001
(51) Int. Cl.: H01L 23/48

(54) **Leistungshalbleitermodul**
Power Semiconductor Modul
Module à semi-conducteurs à haut prestation

(30) Priorität: 28.12.2000 DE 10065495
(43) Veröffentlichungstag der Anmeldung: 03.07.2002
(73) Patentinhaber: SEMIKRON Elektronik GmbH & Co. KG, 90431 Nürnberg (DE)
(72) Erfinder: Kroneder, Christian, 90596 Schwanstetten (DE)

(56) Entgegenhaltungen:
- EP-A- 0 694 964
- DE-A1- 2 452 922
- DE-A1- 19 627 426
- US-A- 4 734 755

## Beschreibung

Es wird ein Leistungshalbleitermodul beschrieben, das bei Druckkontaktierung der Leistungsanschlüsse des mindestens einen darin befindlichen Halbleiterbauelementes einen konstanten Druck der Innenaufbauten bei den verschiedensten Temperaturbelastungen ausweist, und sich so für einen sicheren Betrieb bei höchster Stromdichte im Hochleistungsbereich eignet.

Die Erfindung beschreibt ein Leistungshalbleitermodul, insbesondere ein Stromrichtermodul, das in Druckkontaktausführung für sehr hohe Leistungsanforderungen geeignet ist. Druckkontaktverbindungen sind aus der Technologie der Herstellung von Halbleitermodulen als Verbindungstechnik hinlänglich bekannt. Aus der DE 196 51 632 A1 ist ein solches Leistungshalbleitermodul, in dem die Druckkontaktausführung mittels Dehnschrauben realisiert ist, bekannt, von dem die Erfindung ausgeht. Leistungshalbleitermodule in Form von Scheibenzellen wie sie aus der DE 33 08 661 bekannt sind bilden gleichermaßen den Ausgangspunkt der Erfindung.

Der Druckkontaktaufbau im Inneren des Moduls, insbesondere das Drücken der Kontaktierung auf das Halbleiterbauelement, führt in der Praxis zu verschiedenen Schwierigkeiten. Einerseits muß der unterschiedliche Wärmeausdehnungskoeffizient zwischen dem Halbleiterbauelement und der Kontaktierung überwunden werden, andererseits muß das meist runde Halbleiterbauelement sehr genau zu den Kontaktierungen zentriert werden. Das Halbleiterbauelement, insbesondere der Rand desselben muß hierbei gegen mechanische Beschädigungen geschützt werden.

In der Praxis wird der Halbleiterbauelement beidseitig mit je einem flächigen Metallkörper verbunden, dessen Wärmeausdehnungskoeffizient zwischen dem Wärmeausdehnungskoeffizienten des Halbleiterbauelements und dem Wärmeausdehnungskoeffizienten der Kontaktierung liegt, um den thermischen Streß für das Halbleiterbauelement zu verringern. Die Verbindung des Halbleiterbauelements mit den flächigen Metallkörpern, die vorzugsweise aus Molybdän bestehen, kann durch unterschiedliche Verfahren realisiert werden, beispielhaft durch Verlöten oder Verkleben der beiden Partner. Weiterhin ist eine sogenannte Niedertemperaturverbindung (NTV) oder auch eine Legierung der beiden Partner bekannt. Der flächige Metallkörper weist typischerweise eine Dicke in der Größenordnung einiger zehntel bis einiger weniger Millimeter auf. Der, wie oben beschrieben hergestellte, Verbund erster flächiger Metallkörper - Halbleiterbauelement - zweiter flächiger Metallkörper wird auch als "Sandwich" bezeichnet, weiterhin soll sowohl der stoffschlüssige als auch der stoffbündige Verbund als Sandwich bezeichnet werden.

Das Sandwich wird nach dem Stand der Technik beispielhaft auf ein, z. B. aus Kunststoff hergestelltes, Teil gelegt, welches das Sandwich im Modul zentriert wie in DE 196 51 632 vorgestellt. Besonders bei Modulen hoher Spannungsfestigkeit ist bekannt, dass das Sandwich zusätzlich mit einer elastischen nicht leitenden Masse umspritzt und damit einer Zentrierung zu den Anschlusselementen zugänglich gemacht wird.

Die oben beschriebenen Herstellungsverfahren des Sandwiches weisen folgende Nachteile auf:
- Das Verlöten des Halbleiterbauelements mit dem flächigen Metallkörper führt zu einer Verschlechterung des Wärmewiderstandes, da die Lotschicht eine Wärmebremse darstellt. In ansonsten druckkontaktierten Systemen erweist sich diese Lotschicht als eine zusätzliche Schwachstelle, da diese im Dauerbetrieb ermüdet und so die Lebensdauer des Leistungshalbleitermoduls vermindert.
- Das Verkleben des Leistungshalbleiters mit den flächigen Metallkörpern wird nicht vollflächig zwischen den Partner realisiert - dies würde den Wärmewiderstand noch wesentlich stärker verschlechtern als das verlöten - sondern es werden lediglich einige Millimeter am Rand der Partner verklebt, um einen festen Kontakt herzustellen. Dies führt zu einem weiteren Pröblem: Damit zwischen den Partnern keine Luft eingeschlossen wird - dies würde wiederum den thermischen Übergang verschlechtern - muß dieses Sandwich nach dem Verkleben verpresst werden. Hierbei besteht die erhöhte Gefahr des Brechens des kristallinen Halbleiterbauelements, da es sich, bedingt durch den Kleberand, in der Mitte durchbiegen kann.
- Die Niedertemperaturverbindung (NTV) der Partner ist ein stoffbündiges Verfahren, das die oben beschriebenen Nachteile eliminiert, da die Verbindung einen sehr guten Wärmeübergang gewährleistet. Bei diesem Verfahren werden die Partner durch Druck und Temperatur miteinander verbunden. Der entscheidende Nachteil dieses Verfahrens besteht darin, dass es sehr aufwendig zu realisieren und damit mit hohen Kosten verbunden ist. Daher wird es für Standardmodule nach dem Stand der Technik nicht verwendet.
- Das zusätzliche Verfahren des Umspritzens des Sandwiches ist ebenfalls ein aufwendiger Fertigungsprozess der zu einer Erhöhung der Herstellungskosten beiträgt.

Zusammenfassend ergibt sich, dass die oben beschriebenen Verfahren den Wärmewiderstand des Aufbaus verschlechtern, die Langsamlastwechselfestigkeit verringern, die Gefahr des Bruches des Leistungshalbleiters erhöhen, und / oder sehr teuer sind.

Aus der EP 0 694 964 A2 ist ebenfalls ein Leistungshalbleitermodul in Form einer Scheibenzelle bekannt. Hierbei wird ein Sandwich der oben genannten Art mit einer die beiden flächigen Metallkörper umgebenden Halterung offenbart, wobei diese Halterung das Sandwich die Metallkörper rundunlaufend überdeckend formschlüssig umschließt.

Der Erfindung liegt die Aufgabe zugrunde eine Zentrierung der einzelnen Komponenten des Sandwiches zueinander und zu einem Anschlusselement für den elektrischen Anschluss zu finden, welches einen geringen Wärmewiderstand aufweist, die Dauerhaltbarkeit erhöht, Bruch des Halbleiterbauelements durch Druckeinwirkung durch die Zentrierung selbst ausschließt, sowie kostengünstig in Standardproduktionsverfahren zu integrieren ist.

Die Aufgabe wird erfindungsgemäß gelöst, durch die Maßnahmen der Merkmale des Anspruchs 1. Bevorzugte Ausführungsformen sind in den Unteransprüchen beschrieben.

Die vorzugsweise aus elektrisch isolierendem Kunststoff bestehende rahmenartigen Zentriereinrichtung zur Zentrierung des Sandwiches auf einem elektrischen Anschlusselement weist folgende Merkmale auf:
- Die Einzelelemente des Sandwiches, also die beiden flächigen Metallkörper sowie das Halbleiterbauelement sind nicht durch eine stoffschlüssige Verbindung, wie z.B. Löten miteinander verbunden, sondern befinden sich vor dem Einbau in ein Leistungshalbleitermodul lose in der Zentriereinrichtung. Erst durch den Einbau und die druckbeaufschlagende Druckeinrichtung entsteht eine stoffbündige Verbindung der einzelnen Elemente.
- Die beiden flächigen Metallkörper des Sandwiches werden vor dem Einbau in ein Leistungshalbleitermodul durch Nasen vor dem Herausfallen gesichert. Das einen größeren Durchmesser bzw. eine größere Kantenlänge als die beiden Metallkörper aufweisende Halbleiterbauelement wird durch eine weitere mittig und parallel zu den Oberflächen in der Zentriereinrichtung verlaufende Ausnehmung gehalten. Um sicherzustellen, dass weder vor noch nach dem Einbau der Zentriereinrichtung einschließlich des Sandwiches Druck durch die Zentriereinrichtung selbst auf das Sandwich ausgeübt wird, der z.B. zur Zerstörung des Halbleiterbauelements führen könnte, müssen folgende geometrische Randbedingungen eingehalten werden.
- Das Halbleiterbauelement selbst muss eine geringere Dicke d aufweisen als die Dicke b der mittige in der Zentriereinrichtung verlaufende Ausnehmung zur Halterung des Halbleiterbauelements.
- Die Dicke (c+d+c) des Sandwiches muss geringer sein als der Abstand (a+b+a) der beidseitig angebrachten Nasen zur Halterung der beiden flächigen Metallkörper.
- Die Dicke d des Halbleiterbauelements plus die Dicke c eines der beiden vorzugsweise gleich dicken flächigen Metallkörper zusammen muss größer sein als die Dicke b der mittige in der Zentriereinrichtung verlaufenden Ausnehmung zur Halterung des Halbleiterbauelements.
- Die Dicke d des Halbleiterbauelements plus die Dicke c eines der beiden vorzugsweise gleich dicken flächigen Metallkörper zusammen muss kleiner sein als die Dicke b der mittigen Ausnehmung plus dem Abstand a der mittigen Ausnehmung zu den Nasen.

Dadurch wird erreicht, dass die Zentriereinrichtung geeignet ist zur Aufnahme verschiedener Dicken von flächigen Metallkörpem sowie verschiedener Dicken des Halbleiterbauelements.
- Durch diese Randbedingungen sowie durch die Anordnung von Aussparungen im elektrischen Anschlusselement derart, dass die Nasen zur Halterung der flächigen Metallkörper zumindest vollständig in diesen Aussparungen bei der Montage des Moduls versinken, wird sichergestellt, dass nach der Montage durch die Zentriereinrichtung selbst keinerlei Druck auf das Sandwich bzw. seine Bestandteile ausgeübt wird. Die stoffschlüssige Verbindung wird ausschließlich über das im Leistungshalbleitermodul vorhandene Druckelement hergestellt.
- Die Zentriereinrichtung selbst besteht vorzugsweise aus zwei identischen Teilkörpern, die weitere Nasen sowie Ausnehmungen aufweisen, derart gestaltet, dass die beiden Teile rastend zusammengefügt werden können.

Der erfinderische Gedanke wird anhand der Ausführungsbeispiele in den Fig. 1 bis 7 näher erläutert.
Fig. 1 zeigt die erfinderische Zentriereinrichtung im Querschnitt vor der Montage in ein Leistungshalbleitermodul.
Fig. 2 zeigt einen der beiden identischen erfinderischen Teilkörper der Zentriereinrichtung in Draufsicht.
Fig. 3. zeigt den Teilkörper aus Fig. 2 in einer dreidimensionalen Ansicht.
Fig. 4 zeigt einen Schnitt durch die erfinderische Zentriereinrichtung einschließlich des Sandwiches.
Fig. 5 zeigt die erfinderische Zentriereinrichtung im Querschnitt nach der Montage in ein Leistungshalbleitermodul.
Fig. 6 zeigt ein elektrisches Anschlusselement eines Leistungshalbleitermoduls
Fig. 7 zeigt den inneren Aufbau eines Leistungshalbleitermoduls einschließlich der erfinderischen Zentriereinrichtung

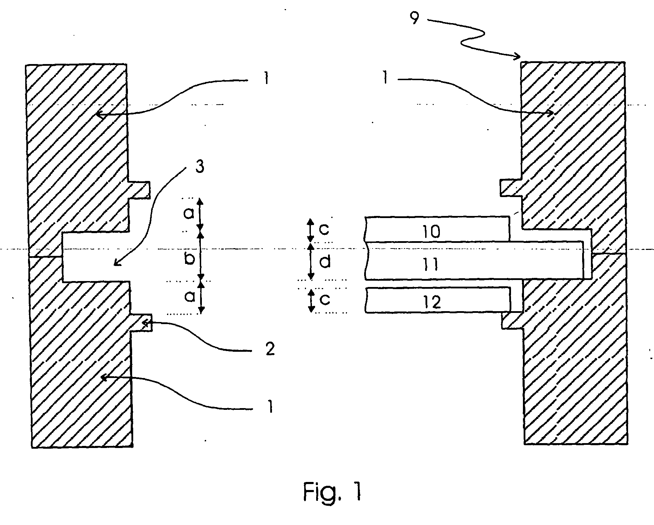

Fig. 1 zeigt die erfinderische rahmenartigen Zentriereinrichtung (9) im Querschnitt vor der Montage in ein Leistungshalbleitermodul. Die Zentriereinrichtung (9) besteht aus zwei identischen Teilkörpern (1). Diese vorzugsweise aus Kunststoff hergestellten Körper weisen Nasen (2) auf, die einen ersten flächigen Metallkörper (12) hier eine Molybdänscheibe gegen Herausfallen aus dem Verbund der Zentriereinrichtung sichern. Das im Vergleich zu den beiden Molybdänscheiben (10, 12) in seinem Durchmesser größere Halbleiterbauelement (11) befindet sich in der mittigen Ausnehmung (3) der Zentriereinrichtung. Die zweite Molybdänscheibe (10) liegt vor der Montage in das Leistungshalbleitermodul lose auf dem Halbleiterbauelement (11) auf. Durch die Zentriereinrichtung (9) können die das Sandwich bildenden Bauteile (10, 11, 12) bereits vor der Montage zueinander zentriert werden, ohne daß zu diesem Zeitpunkt eine stoffschlüssige oder stoffbündige Verbindung hergestellt werden muss.

Der Abstand der Nasen (2) zum Rand der Ausnehmung (3) wird mit a bezeichnet, die Höhe der Ausnehmung (3) mit b. Die Dicke der Molybdänscheiben wird mit c und die des Halbleiterbauelements mit d bezeichnet.

Da die Dicke d des Halbleiterbauelement (11) plus die Dicke a der Molybdänscheibe (10 oder 12) größer ist als die Dicke b der Ausnehmung (3) kann auch die Molybdänscheibe sich zu keinem Zeitpunkt unzentriert zu den restlichen Bauteilen teilweise in dieser Ausnehmung befinden. Damit ist eine Handhabung des zentrierten Sandwiches problemlos möglich.

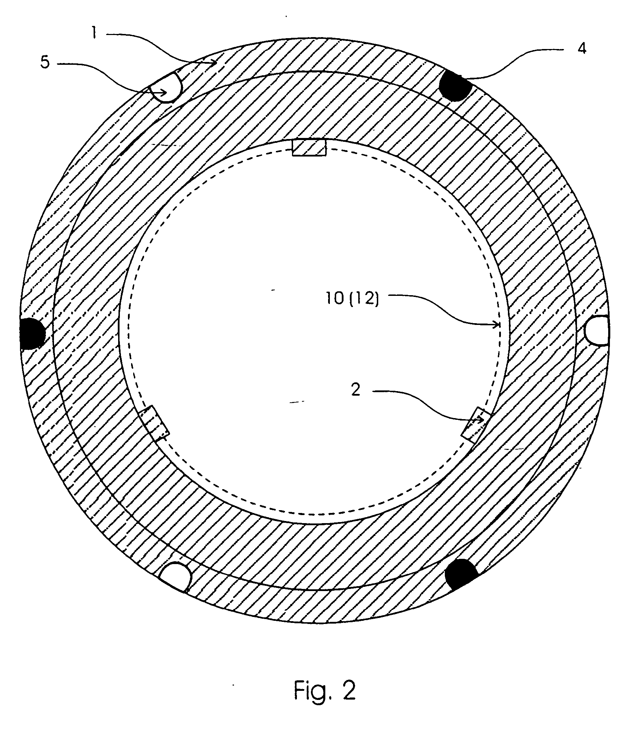

Fig. 2 zeigt nicht maßstäblich einen der beiden identischen erfinderischen Teilkörper (1) der Zentriereinrichtung (9) in Draufsicht. Die Nasen (2) sind derart angeordnet, daß eine Molybdänbscheibe (10, 12) gegen herausfallen aus dem Verbund gesichert ist. Der Teilkörper (1) weist zusätzliche Nasen (4) und Ausnehmungen (5) auf. Diese sind derart gestaltet, dass zwei dieser Teilkörper (1) zusammengesteckt werden können, dabei jeweils eine Nase (4) in eine Ausnehmung (5) greift und somit die beiden Teile rastend zusammengefügt werden können um eine Einheit aus Zentriereinrichtung und Sandwich zu bilden.

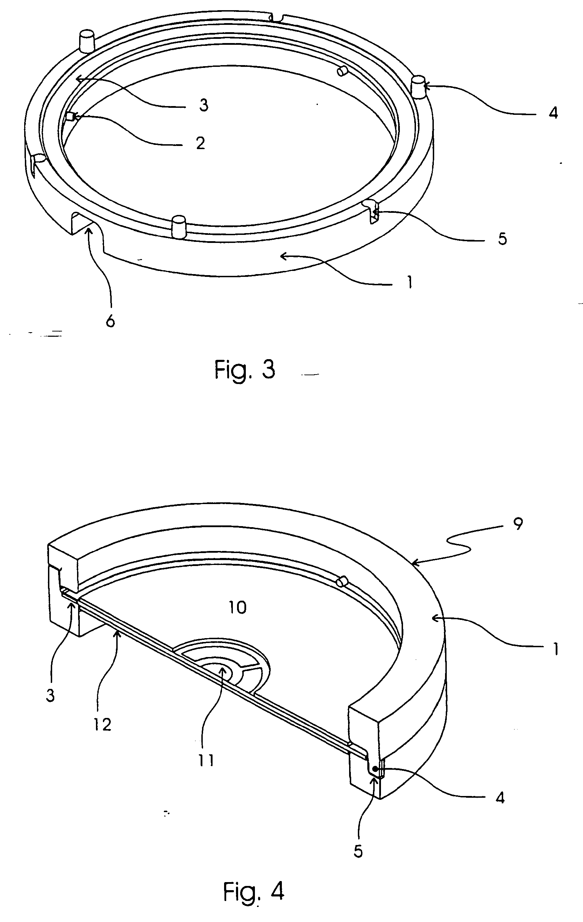

Fig. 3. zeigt den Teilkörper (1) aus Fig. 2 in einer dreidimensionalen Ansicht. Zusätzlich zu den Nasen (2), den Nasen (4) und den zugeordneten Ausnehmungen (5) ist noch eine weitere Ausnehmung (6) vorhanden um zusätzliche Steueranschlüsse des Halbleiterbauelements mit einer Stromzuführung versehen zu können.

Fig. 4 zeigt die erfinderische Zentriereinrichtung (9) einschließlich des Sandwiches im Querschnitt. Dabei ist einer der flächigen Metallkörper als Ring (10) gestaltet um den Steueranschluss des Halbleiterbauelements (11) zugänglich zu halten.

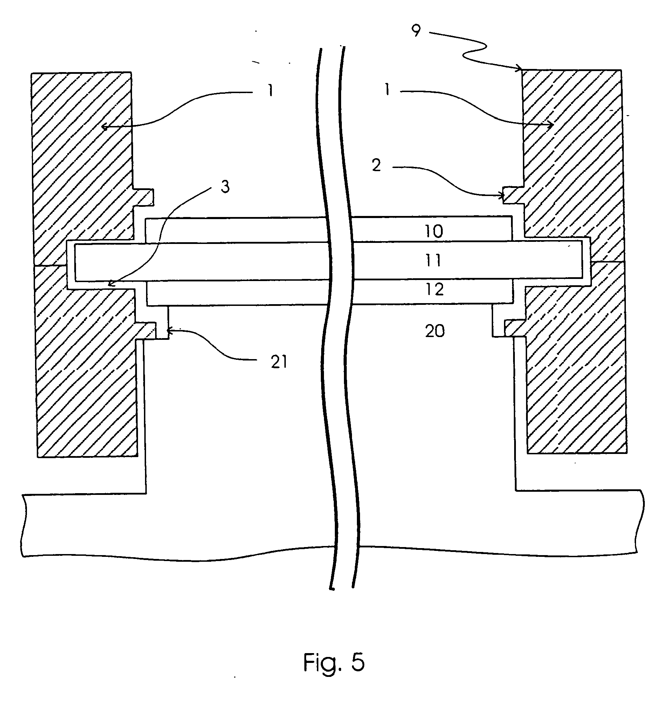

Fig. 5 zeigt die erfinderische rahmenartigen Zentriereinrichtung (9) im Querschnitt nach der Montage in ein Leistungshalbleitermodul. Ein erstes elektrisches Anschlusselement (20) weist Ausnehmungen (21) auf in denen die Nasen (2) mehr als vollständig versinken können. Die erste Molybdänscheibe (12) liegt direkt auf dem elektrischen Anschlusselement (20) auf, darauf befindet sich jeweils ohne Abstand das Halbleiterbauelement (11) sowie die zweite Molybdänscheibe (10). Es ist offensichtlich, dass die Zentriereinrichtung selbst keinerlei Druck auf das Sandwich (10, 11, 12) ausübt und somit eine negative Beeinflussung wie z.B. eine Zerstörung ausgeschlossen ist. Eine Dezentrierung der einzelnen Elemente ist aus analogen Gründen vgl. Beschreibung zu Fig. 1 ausgeschlossen. Die stoffschlüssige Verbindung der Elemente des Sandwiches wird durch eine von oben auf das Sandwich, nicht aber auf die Zentriereinrichtung, einwirkende Druckeinrichtung hergestellt. Die erfinderische Zentriereinrichtung (9) kann somit vor der Modulherstellung mit dem Sandwich als Verbund aufgebaut werden und wirkt ab diesem Zeitpunkt als Zentrierung aller Elemente des Sandwiches ohne Druck auf diese Elemente auszuüben.

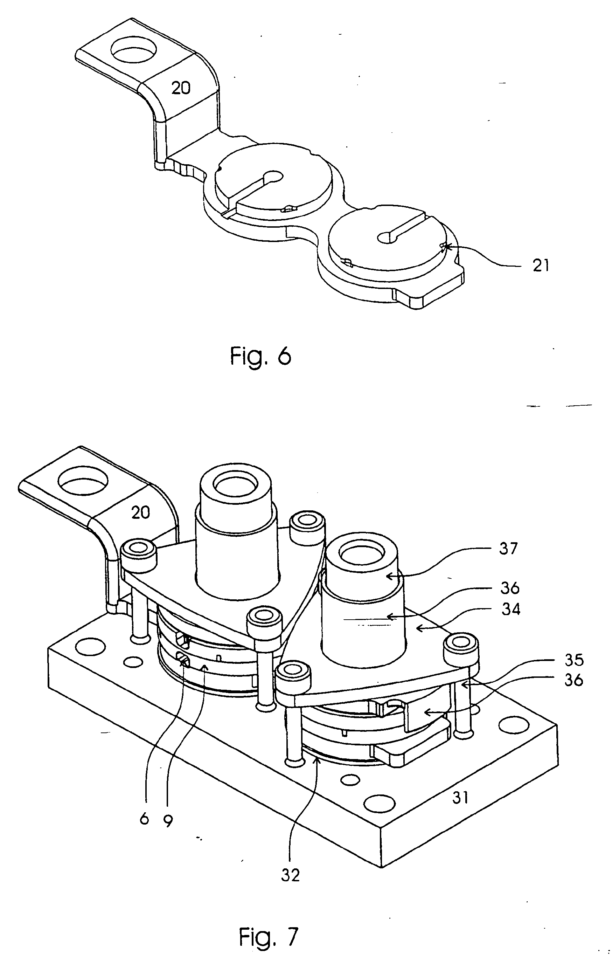

Fig. 6 zeigt ein elektrisches Anschlusselement (20) eines Leistungshalbleitermoduls für zwei Halbleiterbauelementen, also z.B. Thyristormodul. Die Ausnehmung (21) für die Nasen (2) sind dabei ersichtlich.

Fig. 7 zeigt den inneren Aufbau eines Leistungshalbleitermoduls (Thyristormoduls) einschließlich der erfinderischen Zentriereinrichtung (9). Das Modul besteht aus einer Grundplatte (31). Darauf befinden sich zwei Isolierstoffscheiben 32, die beispielhaft aus Aluminiumoxid oder Aluminiumnitrid gebildet werden können, und der elektrischen Isolierung des ersten elektrisches Anschlusselements (20) dienen. Darauf befindet sich das Sandwich in der Zentriereinrichtung (9) mit Aussparung für Steueranschlüsse (6). Das zweite elektrische Anschlusselement (37) wird mittels der Druckplatte (34) und den druckaufbauenden Dehnschrauben (35) auf das Sandwich gedrückt, wobei die druckgebenden Elemente mittels eines Isolierstoffkörpers (36) elektrisch isoliert sind. Durch diesen Aufbau entsteht eine stoffbündige Kontaktierung des zweiten elektrischen Anschlusselements (37) mit der zweiten Molybdänscheibe (10,) dem Halbleiterbauelement (11), der ersten Molybdänscheibe (12) sowie des ersten elektrischen Anschlusselements (20).

## Patentansprüche

1. Leistungshalbleitermodul mit mindestens einem ersten elektrischen Anschlusselement (20), mindestens einem darauf befindlichem Sandwich aus einem ersten flächigen Metallkörper (12), einem Halbleiterbauelement (11) sowie einem zweiten flächigen Metallkörper (10), mit mindestens einem Druckelement (34, 35, 36), mindestens einem zweiten elektrischen Anschlusselement (37) sowie einem Gehäuse, wobei
das Sandwich mittels einer aus zwei Körpern (1) bestehenden rahmenartigen Zentriereinrichtung (9) auf dem ersten elektrischen Anschlusselement (20) zentriert angeordnet ist, wobei die Zentriereinrichtung (9) derart gestaltet ist, dass der erste (12) sowie der zweite (10) flächige Metallkörper mittels Nasen (2) an der Zentriereinrichtung (9) gegen Herausfallen gesichert sind, das einen größeren Durchmesser bzw. eine größere Kantenlänge als die flächigen Metallkörper (10, 12) aufweisende Halbleiterbauelement (11) in einer weiteren mittig und parallel zu den Oberflächen in der Zentriereinrichtung verlaufende Ausnehmung (3) angeordnet ist,
sowie im ersten elektrischen Anschlusselement (20) Ausnehmungen (21) vorgesehen sind derart gestaltet, dass die Nasen (2) der Zentriereinrichtung (9) zur Halterung des ersten flächigen Metallkörpers (12) in der Zentriereinrichtung mehr als vollständig in diesen Ausnehmungen (21) anordenbar sind,
und die Dicke des Sandwiches geringer ist als der Abstand der beidseitig angebrachten Nasen (2) zur Halterung der beiden flächigen Metallkörper (10, 12).

2. Leistungshalbleitermodul nach Anspruch 1, **dadurch gekennzeichnet, dass**
die beiden Teile der Zentriereinrichtung (9) aus nicht leitfähigem Kunststoff bestehen.

3. Leistungshalbleitermodul nach Anspruch 1, **dadurch gekennzeichnet, dass**
die beiden Teile (1) der Zentriereinrichtung (9) weitere Nasen (4) und Ausnehmungen (5) aufweisen, derart gestaltet, dass die beiden Teile rastend zusammengefügt werden können.

4. Leistungshalbleitermodul nach Anspruch 1, **dadurch gekennzeichnet, dass**
als Halbleiterbauelemente (11) Dioden, Thyristoren oder Transistoren verwendet werden.

5. Leistungshalbleitermodul nach Anspruch 1, **dadurch gekennzeichnet, dass**
die flächigen Metallkörper (10, 12) aus Molybdän bestehen.

6. Leistungshalbleitermodul nach Anspruch 1, **dadurch gekennzeichnet, dass**
das Sandwich sowie die Zentriereinrichtung (9) rund oder quadratisch ausgestaltet sind.

7. Leistungshalbleitermodul nach Anspruch 1, **dadurch gekennzeichnet, dass**
die Zentriereinrichtung (9) mindestens eine zusätzliche Randausnehmung (6) zur Durchführung mindestens eines Steueranschlusses des Halbleiterbauelements aufweist.

8. Leistungshalbleitermodul nach Anspruch 1, **dadurch gekennzeichnet, dass**
zur Kontaktierung eventueller im Halbleiterbauelement (11) vorhandener Steueranschlüsse einer oder beide flächigen Metallkörper (10, 12) des Sandwiches ein oder mehrere Durchführungen aufweisen.

9. Leistungshalbleitermodul nach Anspruch 1, **dadurch gekennzeichnet, dass**
das Halbleiterbauelement (11) eine geringere Dicke als die mittige in der Zentriereinrichtung (9) verlaufende Ausnehmung (3) zur Halterung des Halbleiterbauelements (11) aufweist.

10. Leistungshalbleitermodul nach Anspruch 1, **dadurch gekennzeichnet, dass**
die Dicke des Halbleiterbauelements (11) plus die Dicke eines der beiden vorzugsweise gleich dicken flächigen Metallkörpers (10, 12) zusammen größer ist als die Dicke der mittigen in der Zentriereinrichtung verlaufenden Ausnehmung (3) zur Halterung des Halbleiterbauelements (11) sowie kleiner ist als die Dicke der mittigen Ausnehmung (3) plus dem Abstand der mittigen Ausnehmung (3) zu der näher daran befindlichen Nase (2).

## Claims

1. A power semiconductor module with at least one first electrical connection element (20); located on it at least one sandwich of a first planar metal body (12), a semiconductor component (11), and also a second planar metal body (10), with at least one pressure element (34, 35, 36), at least one second electrical connection element (37), and also a housing, wherein
the sandwich is arranged centred on a first electrical connection element (20) by means of a frame type centring device (9) consisting of two bodies (1), wherein
the centring device (9) is configured such that the first (12) and also the second (10) planar metal body are secured against falling out by means of noses (2) on the centring device (9), the semiconductor component (11), having a larger diameter and/or a larger edge length than the planar metal bodies (10, 12), is arranged in a further central recess (3) running parallel to the surfaces in the centring device,
and also recesses (21) provided in the first electrical connection element (20) are configured such that the noses (2) of the centring device (9) can be arranged more than completely in these recesses (21) for the retention of the first planar metal body (12) in the centring device,
and the thickness of the sandwich is less than the distance between the noses (2) fitted on both sides for the retention of the two planar metal bodies (10, 12).

2. The power semiconductor module according to Claim 1, **characterised in that** both parts of the centring device (9) consist of a non-conducting plastic.

3. The power semiconductor module according to Claim 1, **characterised in that** both parts (1) of the centring device (9) have further noses (4) and recesses (5) configured such that the two parts can be joined together in a latching manner.

4. The power semiconductor module according to Claim 1, **characterised in that** diodes, thyristors or transistors are used as semiconductor components (11).

5. The power semiconductor module according to Claim 1, **characterised in that** the planar metal bodies (10, 12) consist of molybdenum.

6. The power semiconductor module according to Claim 1, **characterised in that** the sandwich and also the centring device (9) are configured in a round or quadratic form.

7. The power semiconductor module according to Claim 1, **characterised in that** the centring device (9) has at least one additional edge recess (6) for the feed-through of at least one control connection of the semiconductor component.

8. The power semiconductor module according to Claim 1, **characterised in that** for the contacting of control connections possibly present in the semiconductor component (11) one or both planar metal bodies (10, 12) of the sandwich have one or a plurality of feed-throughs.

9. The power semiconductor module according to Claim 1, **characterised in that** the semiconductor component (11) has a smaller thickness than the recess (3) running centrally in the centring device (9) for the retention of the semiconductor component (11).

10. The power semiconductor module according to Claim 1, **characterised in that** the thickness of the semiconductor component (11) plus the thickness of one of the two preferably of equal thickness planar metal bodies (10, 12) together is greater than the thickness of the recess (3) running centrally in the centring device (9) for the retention of the semiconductor component (11), and also is smaller than the thickness of the central recess (3) plus the distance of the central recess (3) to the nose (2) that is located nearer to it.

## Revendications

1. Module semi-conducteur de puissance, comportant au moins un premier élément de raccordement électrique (20), sur lequel est situé au moins un sandwich constitué d'un premier corps métallique plat (12), d'un composant semi-conducteur (11) ainsi que d'un deuxième corps métallique plat (10), au moins un élément de pression (34, 35, 36), au moins un deuxième élément de raccordement électrique (37) ainsi qu'un boîtier, le sandwich étant disposé de façon centrée sur le premier élément de raccordement électrique (20) au moyen d'un dispositif de centrage (9) de type cadre constitué de deux corps (1), le dispositif de centrage (9) étant agencé de telle sorte que le premier corps métallique plat (12), ainsi que le deuxième (10), soient bloqués vis-à-vis d'une chute au moyen de taquets (2) prévus sur le dispositif de centrage (9), que le composant semi-conducteur (11), ayant diamètre plus important ou une longueur de bord plus importante que les corps métalliques plats (10, 12), soit disposé dans un autre évidement (3) s'étendant de façon centrale et parallèlement aux surfaces dans le dispositif de centrage, et
des évidements (21) étant prévus dans le premier élément de raccordement électrique (20), qui sont agencés de telle sorte que, pour le maintien du premier corps métallique plat (12) dans le dispositif de centrage, les taquets (2) du dispositif de centrage (9) puissent être logés plus que complètement dans ces évidements (21), et
l'épaisseur du sandwich étant inférieure à l'écartement entre les taquets (2) fixés de part et d'autre pour le maintien des deux corps métalliques plats (10, 12).

2. Module semi-conducteur de puissance selon la revendication 1, **caractérisé en ce que** les deux parties du dispositif de centrage (9) sont en matière plastique non conductrice.

3. Module semi-conducteur de puissance selon la revendication 1, **caractérisé en ce que** les deux parties (1) du dispositif de centrage (9) comportent d'autres taquets (4) et évidements (5), qui sont agencés de telle sorte que les deux parties puissent être assemblées par encliquetage.

4. Module semi-conducteur de puissance selon la revendication 1, **caractérisé en ce que** des diodes, des thyristors ou des transistors sont utilisés en tant que composants semi-conducteurs (11).

5. Module semi-conducteur de puissance selon la revendication 1, **caractérisé en ce que** les corps métalliques plats (10, 12) sont en molybdène.

6. Module semi-conducteur de puissance selon la revendication 1, **caractérisé en ce que** le sandwich ainsi que le dispositif de centrage (9) sont agencés de façon circulaire ou quadratique.

7. Module semi-conducteur de puissance selon la revendication 1, **caractérisé en ce que** le dispositif de centrage (9) comporte au moins un évidement de bord (6) supplémentaire pour le passage d'au moins un raccordement de commande du composant semi-conducteur.

8. Module semi-conducteur de puissance selon la revendication 1, **caractérisé en ce que**, pour l'établissement du contact d'éventuels raccordements de commande prévus dans le composant semi-conducteur (11), l'un ou les deux corps métalliques plats (10, 12) du sandwich comportent un ou plusieurs passages.

9. Module semi-conducteur de puissance selon la revendication 1, **caractérisé en ce que** l'épaisseur du composant semi-conducteur (11) est plus faible que l'évidement (3) central s'étendant dans le dispositif de centrage (9) pour le maintien du composant semi-conducteur (11).

10. Module semi-conducteur de puissance selon la revendication 1, **caractérisé en ce que** l'épaisseur du composant semi-conducteur (11), plus l'épaisseur de l'un des deux corps métalliques plats (10, 12) ayant de préférence la même épaisseur, est plus importante que l'épaisseur de l'évidement central (3) s'étendant dans le dispositif de centrage pour le maintien du composant semi-conducteur (11), et est inférieure à l'épaisseur de l'évidement central (3), plus l'écartement de l'évidement central (3) par rapport au taquet (2) le plus proche.
